(19) Europäisches Patentamt
European Patent Office
Office européen des brevets

(11) **EP 2 219 232 A1**

## (12) EUROPEAN PATENT APPLICATION
published in accordance with Art. 153(4) EPC

(43) Date of publication:
**18.08.2010 Bulletin 2010/33**

(21) Application number: **08849487.7**

(22) Date of filing: **13.11.2008**

(51) Int Cl.:
*H01L 33/00* (2010.01)   *H01L 21/60* (2006.01)
*H01S 5/022* (2006.01)

(86) International application number:
**PCT/JP2008/003307**

(87) International publication number:
**WO 2009/063638 (22.05.2009 Gazette 2009/21)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **15.11.2007   JP 2007296538**

(71) Applicant: **Panasonic Corporation**
**Kadoma-shi**
**Osaka 571-8501 (JP)**

(72) Inventor: **KAMEI, Hidenori**
**Osaka-shi, Osaka 540-6207 (JP)**

(74) Representative: **Grünecker, Kinkeldey,**
**Stockmair & Schwanhäusser**
**Anwaltssozietät**
**Leopoldstrasse 4**
**80802 München (DE)**

(54) **SEMICONDUCTOR LIGHT EMITTING DEVICE**

(57)     In semiconductor light-emitting devices in which a light-emitting layer is formed on one surface of a substrate, and an n-side electrode and a p-side electrode are formed over the same surface of the substrate as the light-emitting layer, heat generated by a semiconductor light-emitting element needs to be dissipated to a submount. However, it is extremely complicated to fabricate connection members serving also as heat dissipating members and to control fabrication of the connection members, according to semiconductor light-emitting elements having electrodes of various sizes and shapes. By increasing the density of p-side bumps near the n-side electrode, the heat transfer area from the semiconductor light-emitting element to the submount is increased near the n-side electrode, whereby the heat dissipation effect is enhanced.

FIG.1

EP 2 219 232 A1

**Description**

TECHNICAL FIELD

The present invention relates to semiconductor light-emitting devices, and more particularly to semiconductor light-emitting devices in which a semiconductor light-emitting element, which has an n-side electrode and a p-side electrode over one surface of a substrate, is placed on a submount.

BACKGROUND ART

Semiconductor light-emitting elements for use in light-emitting diodes and laser diodes are produced by forming a light-emitting layer on a sapphire or GaN substrate. One type of semiconductor light-emitting element, which has a current supplying electrode formed on one surface of a substrate, emits light from the other surface of the substrate, on which the light-emitting layer is not formed. This type of semiconductor light-emitting element is capable of emitting a large amount of light since no electrode need be provided on the light-emitting surface for emitting light.
In recent years, semiconductor light-emitting elements have been used for lighting applications. The aforementioned type of semiconductor light-emitting element has been increasingly used, and power supply has been increased in order to increase the amount of light emission. This type of semiconductor light-emitting element, which has a current supplying electrode formed on one surface of the substrate, is typically mounted on a part for supplying a current, called a submount, and dissipates heat to the submount. A current-carrying electrode is provided between the semiconductor light-emitting element and the submount, and this electrode often serves also as a heat dissipating member.
Patent Document 1 discloses a semiconductor light-emitting device in which a bump electrode is provided in each light-emitting element in order to increase heat dissipation efficiency. Each bump electrode is connected to a corresponding anode electrode (which is a p-side electrode), and is sized so as to cover substantially the entire surface of the anode electrode (see claim 3 of Patent Document 1).
Patent Document 2 also discloses that first and second large bumps are provided as electrodes in order to enhance a heat dissipation effect, and the total planar cross-sectional area of the large bumps is at least 30% of the planar cross-sectional area of a semiconductor light-emitting element (see claim 2 of Patent Document 2). The first and second bumps are bumps connected to a p-side electrode and an n-side electrode, respectively.

CITATION LIST

PATENT DOCUMENT

   PATENT DOCUMENT 1: Japanese Published Patent Application No. 2005-64412
   PATENT DOCUMENT 2: Japanese Published Patent Application No. 2003-218403

SUMMARY OF THE INVENTION

TECHNICAL PROBLEM

Supplying a large current to a semiconductor light-emitting element generates heat since the semiconductor light-emitting element releases excess energy, which fails to be converted to light, as heat. The type of semiconductor light-emitting element, which has a current supplying electrode formed on one surface of a substrate, needs to dissipate heat via a connection electrode that is provided between the semiconductor light-emitting element and the submount.
The amount of heat dissipation is determined by the contact area, and the thermal conductivity of the material of the connection electrode. Thus, increasing the contact area as in the above Patent Documents is reasonable in order to enhance the heat dissipation effect. However, there are various types of semiconductor light-emitting elements, and manufactures need to fabricate semiconductor light-emitting elements of various sizes according to applications.
In this case, fabricating connection electrodes according to the individual electrode shapes of semiconductor light-emitting elements increases the number of kinds of parts, complicating the process control. The present invention was developed in view of this problem.

SOLUTION TO THE PROBLEM

In order to solve the above problem, a semiconductor light-emitting device according to the present invention

## EP 2 219 232 A1

includes: a submount having a p-side extended electrode and an n-side extended electrode, which are formed on one surface thereof; a p-side connection member formed on an upper surface of the p-side extended electrode, and an n-side connection member formed on an upper surface of the n-side extended electrode; and a semiconductor light-emitting element having a light-emitting layer on one surface thereof, and having a p-side electrode and an n-side electrode on one surface of the light-emitting layer, the p-side electrode being electrically connected to the p-side extended electrode via the p-side connection member, and the n-side electrode being electrically connected to the n-side extended electrode via the n-side connection member, wherein multiple ones of the p-side connection member are provided, the one surface of the light-emitting layer is formed by a first region located within a predetermined distance from the n-side electrode, and a second region other than the first region, and the predetermined distance is such that an area of the first region is one third of that of the second region, and a sum x of bottom areas of the p-side connection members located in the first region is larger than one third of a sum y of bottom areas of the p-side connection members located in the second region.

### ADVANTAGES OF THE INVENTION

With the above configuration, a relatively large number of p-side connection members are located near the n-side connection member, thereby enhancing the heat dissipation effect near the n-side connection member. The above configuration also eliminates the need to individually fabricate electrodes capable of dissipating heat, according to the types of semiconductor light-emitting devices.

### BRIEF DESCRIPTION OF THE DRAWINGS

[FIG. 1] FIG. 1A is a schematic cross-sectional view of a semiconductor light-emitting device according to an embodiment, and FIG. 1B is a schematic plan view thereof.
[FIG. 2] FIGS. 2A and 2B are diagrams showing the configuration of a semiconductor light-emitting device of a comparative example of the embodiment.
[FIG. 3] FIGS. 3A and 3B are diagrams illustrating a variation of the semiconductor light-emitting device of the embodiment.
[FIG. 4] FIGS. 4A and 4B are diagrams illustrating variations of the semiconductor light-emitting device of the embodiment.
[FIG. 5] FIGS. 5A and 5B are diagrams illustrating variations of the semiconductor light-emitting device of the embodiment.
[FIG. 6] FIGS. 6A and 6B are diagrams showing the configuration of a semiconductor light-emitting element.
[FIG. 7] FIGS. 7A and 7B are diagrams showing the configuration of a submount.

### DESCRIPTION OF REFERENCE CHARACTERS

| 1 | Semiconductor Light-Emitting Device |
| 10 | Semiconductor Light-Emitting Element |
| 11 | Substrate |
| 12 | n-Type Layer |
| 13 | Active Layer |
| 14 | p-Type Layer |
| 15 | Light-Emitting Layer |
| 15a-15e | Light-Emitting Layer |
| 16 | n-Side Electrode |

| 16a-16e | n-Side Electrode |
|---------|------------------|
| 17 | p-Side Electrode |
| 17a-17e | p-Side Electrode |
| 21 | Submount |
| 22 | n-Side Extended Electrode |
| 23 | p-Side Extended Electrode |
| 24 | n-Side Bump |
| 24a-24e | n-Side Bump |
| 25 | p-Side Bump |
| 25a-25e | p-Side Bump |
| 100-105 | First Region |
| 200-205 | Second Region |

DESCRIPTION OF EMBODIMENTS

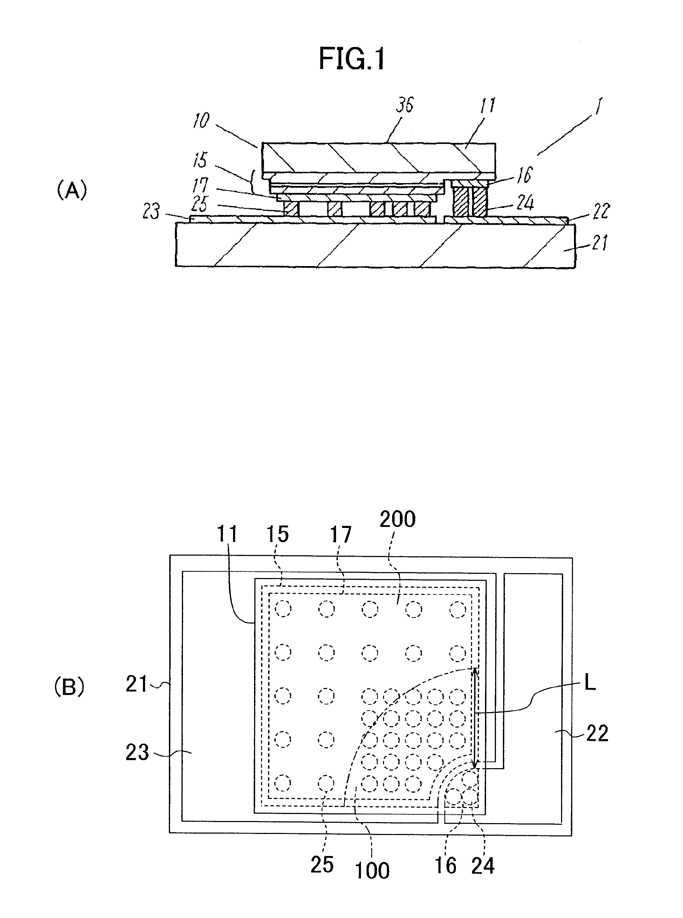

FIGS. 1A-1B show an example semiconductor light-emitting device 1. FIG. 1A is a cross-sectional view, and FIG. 1B is a plan view. The semiconductor light-emitting device 1 is structured so that a semiconductor light-emitting element 10 is fixed to a submount 21.

The semiconductor light-emitting element 10 is structured so that a light-emitting layer 15 including an n-type layer and a p-type layer is laminated on a substrate 11. An n-side electrode 16 is formed on the n-type layer, and a p-side electrode 17 is formed on the p-type layer. A surface of the substrate 11, on which the light-emitting layer 15 is not formed, serves as a light-emitting surface 36 for emitting light. In FIG. 1A, the n-side electrode 16 and the p-side electrode 17 are formed on the lower surface (one surface) of the semiconductor light-emitting element 10.

Extended electrodes 22, 23 are formed on one surface (the upper surface) of the submount 21. The extended electrodes 22, 23 are electrodes for supplying a current to the semiconductor light-emitting element 10. The n-side extended electrode 22 is connected to the n-type layer of the semiconductor light-emitting element 10, and the p-side extended electrode 23 is connected to the p-type layer of the semiconductor light-emitting element 10.

N-side bumps 24 are formed on the upper surface of the n-side extended electrode 22 so as to be connected to the n-side electrode 16 of the semiconductor light-emitting element 10. P-side bumps 25 are formed on the upper surface of the p-side extended electrode 23 so as to be connected to the p-side electrode 17 of the semiconductor light-emitting element 10. That is, the n-side bumps 24 are n-side connection members, and the p-side bumps 25 are p-side connection members. In FIGS. 1A-1B, a plurality of n-side bumps and a plurality of p-side bumps are provided, and are collectively represented by reference characters 24, 25, respectively. Note that the respective lower surfaces of the n-side extended electrode 22 and the p-side extended electrode 23 are in contact with the upper surface of the submount 21.

The semiconductor light-emitting device 1 of FIG. 1 has no p-type layer in a portion where the n-side electrode 16 is formed. Thus, the semiconductor light-emitting device 1 does not emit light in this portion. In order to increase luminous efficiency, the area of the portion where the n-side electrode 16 is formed needs to be as small as possible. On the other hand, since the p-side electrode 17 is formed on one surface of the light-emitting layer 15, a portion where the p-side electrode 17 is formed may have a large area.

If the n-side electrode 16 and the p-side electrode 17 have different areas from each other in this manner, a current flow is concentrated near the n-side electrode 16. Thus, heat generation increases near the n-side electrode 16, and the temperature in this region becomes higher than in other regions, thereby reducing the luminous efficiency. Accordingly, the heat transfer area of the semiconductor light-emitting element 10 to the submount 21 is increased near the n-side electrode 16 to enhance a heat dissipation effect near the n-side electrode 16.

More specifically, the p-side bumps 25 for conducting heat from the semiconductor light-emitting element 10 to the submount 21 are arranged so that a large number of p-side bumps 25 are located near the n-side electrode 16, and a small number of p-side bumps 25 are located in a region away from the n-side electrode 16. More precisely, provided that a first region 100 is a region located within a predetermined distance from the n-side electrode 16 in the one surface of the light-emitting layer 15 on which the p-side electrode 17 is formed, and a second region 200 is a region other than the first region 100 in the one surface of the light-emitting layer 15, the sum x of the bottom areas of the p-side bumps 25 in the first region 100 and the sum y of the bottom areas of the p-side bumps 25 in the second region 200 satisfy the following relation.

$$x/(\text{the area of the first region}) > y/(\text{the area of the second region})$$

The bottom area of the p-side bump 25 refers to the area of the bottom surface of the p-side bump 25, which is in contact with the upper surface of the p-side electrode 17.

In FIG. 1B, the first region 100 is a region in a sector, which is located within a predetermined distance L from the n-side region 16, and the second region 200 is a region other than the first region 100 in the one surface of the light-emitting layer 15 on which the p-side electrode 17 is formed.

If the area of the first region 100 is too small relative to the area of the one surface of the light-emitting layer 15, the heat dissipation effect may not be sufficient even if the above relation is satisfied. On the contrary, if the area of the first region 100 is too large, an excessive number of p-side bumps 25 can exist when the above relation is satisfied. Thus, the first region 100 and the second region 200 are formed so that the area of the first region 100 is one third of that of the second region 200. This can produce a sufficient heat dissipation effect and secure a necessary and sufficient number of p-side bumps 25 when the above relation is satisfied. If the area of the first region 100 is one third of that of the second region 200, the above relation "x/(the area of the first region) > y/(the area of the second region)" is represented by "x/y > 1/3."

For example, if the first region 100 and the second region 200 are arranged so as to form a part of concentric circles about the n-side electrode 16, and the area of the first region 100 is one third of that of the second region 200, the first region 100 is within the range of a radius r from the n-side electrode 16, and the second region 200 is located outside the first region 100, and is within the range of a radius 2r from the n-side electrode 16. It should be noted that the area of the first region 100 need not necessarily be exactly one third of that of the second region 200, and may be within ±20% of one third of the area of the second region 200.

The heat dissipation effect near the n-side electrode 16 is enhanced if "x/(the area of the first region)" is larger than "y/(the area of the second region)." In order to further enhance the heat dissipation effect, "x/(the area of the first region)" is preferably at least 1.2 times "y/(the area of the second region)," more preferably at least 1.5 times "y/(the area of the second region)," and even more preferably at least two times "y/(the area of the second region)." In FIG. 1B, "x/(the area of the first region)" is about three times "y/(the area of the second region)."

In the semiconductor light-emitting device 1 of FIGS. 1A-1B, the plurality of p-side bumps 25 having the same shape and the same bottom area are arranged so as to satisfy the relation "x/(the area of the first region) > y/(the area of the second region)." That is, the density of the p-side bumps 25 is increased near the n-side electrode 16, and is decreased in the region away from the n-side electrode 16.

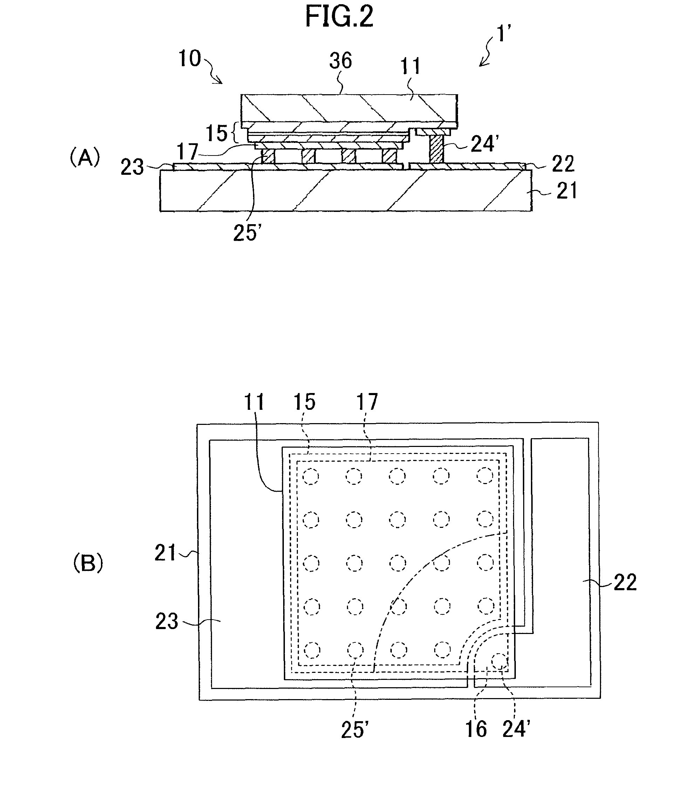

In a comparative semiconductor light-emitting device 1' shown in FIGS. 2A-2B, the density of p-side bumps 25' is constant both near the n-side electrode 16 and in a region away from the n-side electrode 16. Thus, the heat dissipation effect is not enhanced near the n-side electrode 16 as in the semiconductor light-emitting device 1 of FIGS. 1A-1B. Note that although only one n-side bump 24' is provided in FIGS. 2A-2B, three n-side bumps 24 are provided in FIGS. 1A-1B, and the total bottom area of the n-side bumps 24 is larger than the bottom area of the n-side bump 24' in FIGS. 2A-2B. In this regard as well, the semiconductor light-emitting device 1 of FIGS. 1A-1B has a higher heat dissipation effect near the n-side electrode 16 than the comparative semiconductor light-emitting device 1' of FIGS. 2A-2B.

Modifications will be described below with reference to a semiconductor light-emitting element.

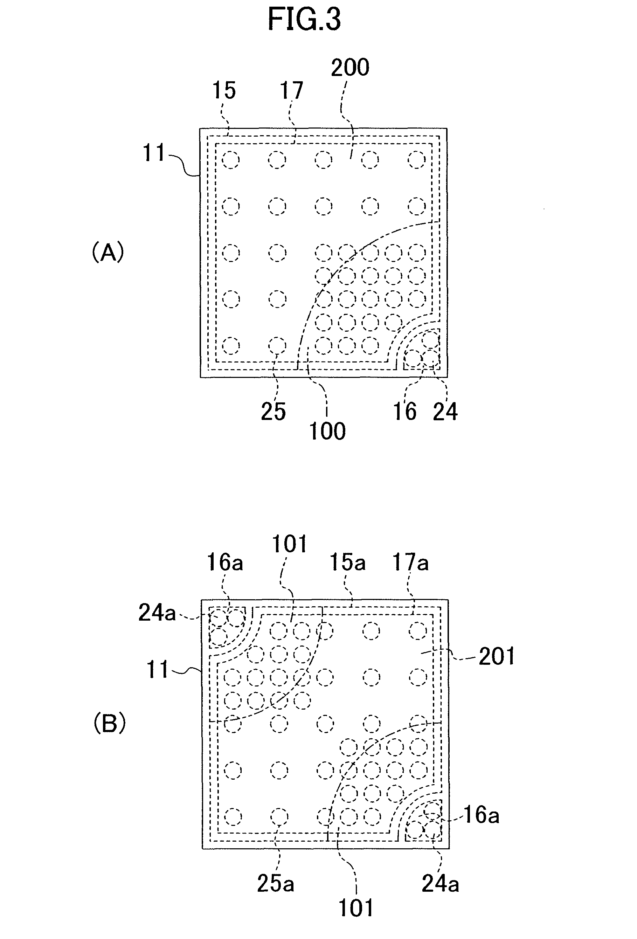

FIG. 3A is a diagram showing only the semiconductor light-emitting element of FIG. 1B.

In a semiconductor light-emitting element of FIG. 3B, two n-side electrodes 16a, 16a are formed in two diagonally opposite corners of a rectangular substrate 11. Thus, two first regions 101, 101 corresponding to the two n-side electrodes 16a, 16b are defined on one surface of a light-emitting layer 15a, and a second region 201 is located between the first regions 101, 101. The sum of the areas of the two first regions 101, 101 is one third of the area of the second region 201. In this example, the sum x of the bottom areas of p-side bumps 25a located in the two first regions 101, 101 is about 1.2 times the sum y of the bottom areas of p-side bumps 25a located in the second region 201, and x/y > 1/3. Three n-side bumps 24a are positioned on each n-side electrode 16a, 16a. The p-side bumps 25a are connected to a p-side electrode 17a.

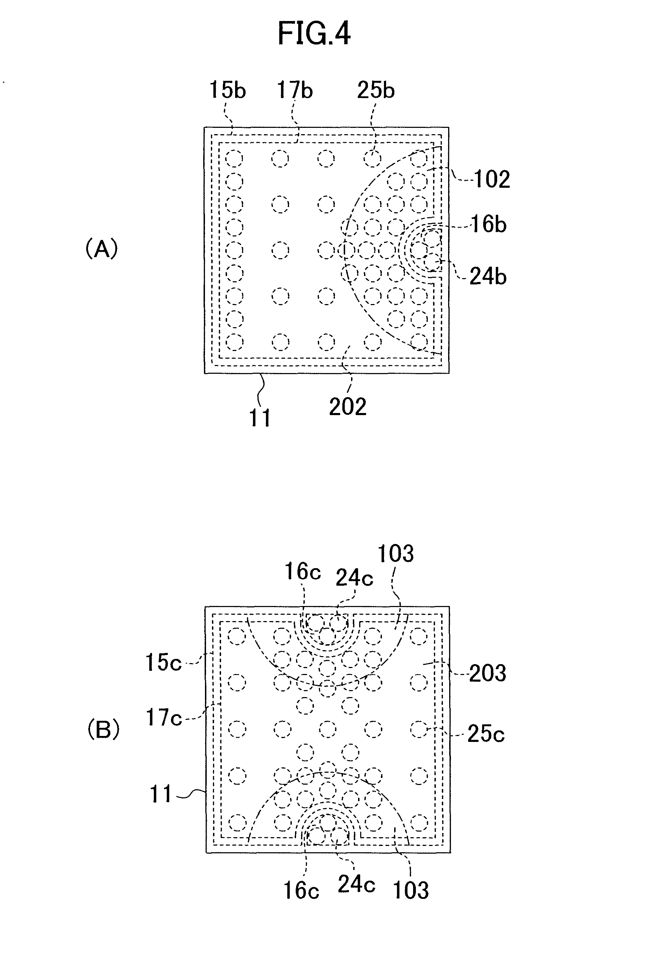

In semiconductor light-emitting elements shown in FIGS. 4A-4B, one or two n-side electrodes 16b, 16c are formed on one or two sides of a substrate 11.

In the semiconductor light-emitting element of FIG. 4A, one n-side electrode 16b is formed in the middle of one side of the rectangular substrate 11. In this example, a first region 102 in one surface of a light-emitting layer 15b is substantially semicircular, and the area of the first region 102 is one third of that of a second region 202. The sum x of the bottom areas of p-side bumps 25b located in the first region 102 is about the same as the sum y of the bottom areas of p-side bumps 25b located in the second region 202, and x/y > 1/3. Three n-side bumps 24b are positioned on the n-side electrode 16b. The p-side bumps 25b are connected to a p-side electrode 17b.

In the semiconductor light-emitting element of FIG. 4B, two n-side electrodes 16c, 16c are formed in the middle of two opposite sides of a rectangular substrate 11. Thus, two first regions 103, 103 corresponding to the two n-side electrodes 16c, 16c are defined on one surface of a light-emitting layer 15c, and a second region 203 is located between the first regions 103, 103. The sum of the areas of the two first regions 103, 103 is one third of that of the second region 203. The sum x of the bottom areas of p-side bumps 25c located in the two first regions 103, 103 is about 0.6 times the sum y of the bottom areas of p-side bumps 25c located in the second region 203, and x/y > 1/3. Three n-side bumps 24c are positioned on each n-side electrode 16c, 16c. The p-side bumps 25c are connected to a p-side electrode 17c.

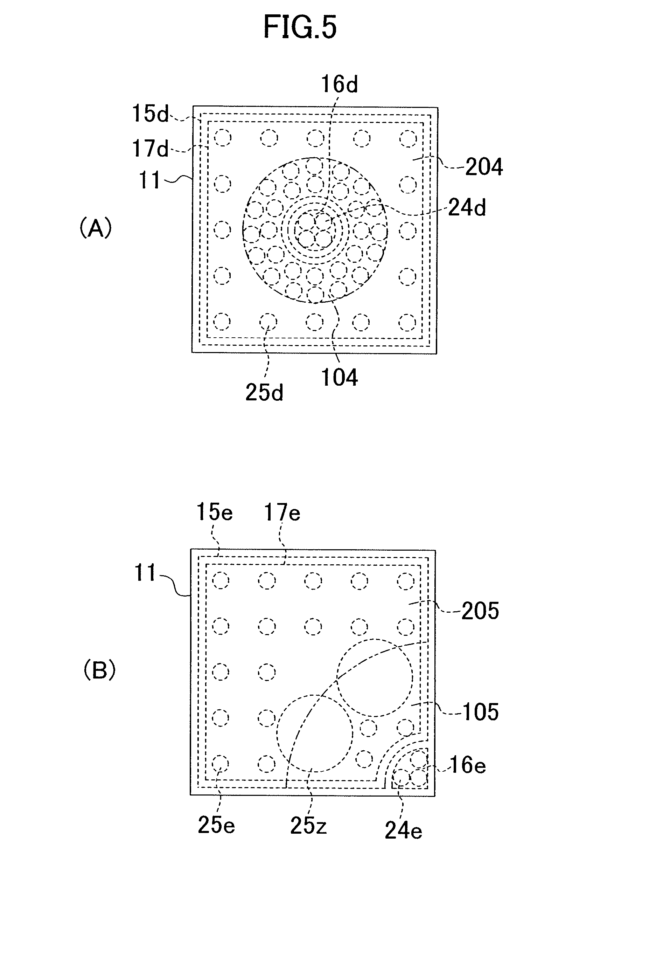

In a semiconductor light-emitting element of FIG. 5A, an n-side electrode 16d is formed in the center of a rectangular substrate 11. A first region 104 in one surface of a light-emitting layer 15d is circular, and the area of the first region 104 is one third of that of a second region 204. The sum x of the bottom areas of p-side bumps 25d located in the first region 104 is about 1.7 times the sum y of the bottom areas of p-side bumps 25d located in the second region 204, and x/y > 1/3. Four n-side bumps 24d are positioned on the n-side electrode 16d. The p-side bumps 25d are connected to a p-side electrode 17d.

In a semiconductor light-emitting element of FIG. 5B, an n-side electrode 16e is formed in one corner of a rectangular substrate 11 as in FIG. 3A. A first region 105 and a second region 205 in one surface of a light-emitting layer 15e are the same in shape and size as the first region 100 and the second region 200 of the semiconductor light-emitting element of FIG. 1B. The semiconductor light-emitting element of FIG. 5B is different from that of FIG. 1B in that the semiconductor light-emitting element of FIG. 5B has two types of p-side bumps 25e, 25z having different sizes from each other. The bottom area of the larger p-side bump 25z is about 30 times that of the smaller p-side bump 25e. The semiconductor light-emitting element of FIG. 5B has two larger p-side bumps 25z, and most of the bottom surfaces of the p-side bumps 25z is located in the first region 105. The sum x of the bottom areas of the p-side bumps 25e, 25z located in the first region 105 is about 1.4 times the sum y of the bottom areas of the p-side bumps 25e, 25z located in the second region 205, and x/y > 1/3. Three n-side bumps 24e are positioned on the n-side electrode 16e. The p-side bumps 25e, 25z are connected to a p-side electrode 17e.

As described above, in the above example semiconductor light-emitting device, the density of the bottom areas of the p-side bumps is higher in the vicinity of the n-side electrode than in the region away from the n-side electrode. This enhances the effect of heat dissipation from the semiconductor light-emitting element to the submount.

Possible materials of the example semiconductor light-emitting device will be described below.

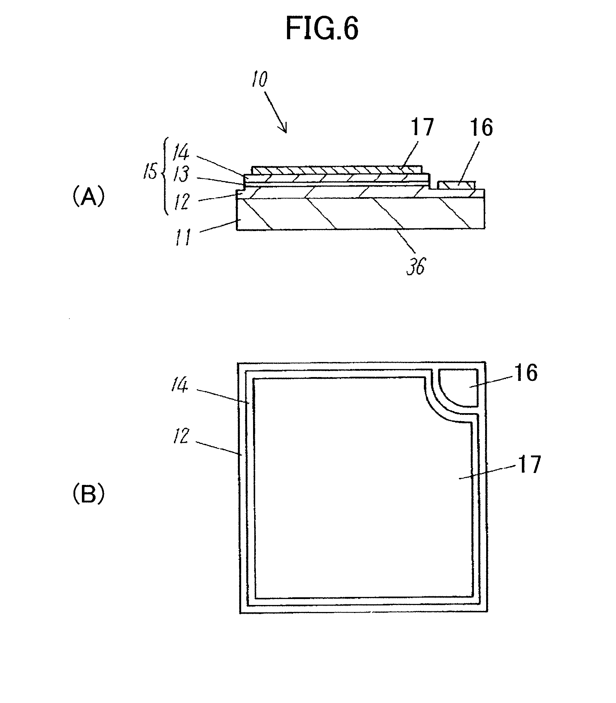

FIG. 6A is a cross-sectional view of the semiconductor light-emitting element 10 corresponding to the semiconductor light-emitting device 1 of FIG. 1A, and FIG. 6B is a plan view as viewed from the electrode plane side. The semiconductor light-emitting element 10 is formed by a substrate 11, an n-type layer 12, an active layer 13, a p-type layer 14, an n-side electrode 16, and a p-side electrode 17. The n-side layer 12, the active layer 13, and the p-side layer 14 are collectively referred to as a light-emitting layer 15. A surface of the substrate 11, on which the light-emitting layer 15 is not formed, serves as a light-emitting surface 36.

The substrate 11 serves to hold the light-emitting layer 15. The substrate 11 can be made of an insulating material such as sapphire. However, it is a primary object of the above embodiment to diffuse heat that is generated by current concentration in the case where the n-side electrode 16 is provided at one or several positions on the substrate 11. Thus, it is more preferable to use a conductive substrate as the substrate 11. More specifically, in the case of using gallium nitride (GaN) as a base material of a light-emitting portion, it is preferable to use as the substrate 11 a conductive substrate having about the same refractive index as that of the light-emitting layer 15, such as GaN, SiC, AlGaN, or AlN, in order to reduce reflection of light at the interface between the n-type layer 12 and the substrate 11. In the case of using zinc oxide (ZnO) as a base material of the light-emitting portion, ZnO is preferable as a material of the substrate 11.

The n-type layer 12, the active layer 13, and the p-type layer 14 of the light-emitting layer 15 are sequentially laminated on the substrate 11. Although the respective materials of the n-type layer 12, the active layer 13, and the p-type layer 14 are not specifically limited, each of the n-type layer 12, the active layer 13, and the p-type layer 14 is preferably made of a GaN compound. More specifically, the n-type layer 12, the active layer 13, and the p-type layer 14 are preferably made of GaN, InGaN, and GaN, respectively. Note that AlGaN or InGaN may be used as the n-type layer 12 and the p-type layer 14. A GaN or InGaN buffer layer may further be provided between the n-type layer 12 and the substrate 11. For example, the active layer 13 may have a multilayer structure (a quantum well structure) in which InGaN and GaN layers are alternately laminated.

In this light-emitting layer 15 formed by laminating the n-type layer 12, the active layer 13, and the p-type layer 14, the active layer 13 and the p-type layer 14 are removed in a part of the surface of the light-emitting layer 15 to expose the n-type layer 12. The n-side electrode 16 is formed on the exposed n-type layer 12. Note that in the case of the conductive substrate 11, the n-type layer 12 may also be removed to form the n-side electrode 16 directly on the substrate 11. The p-side electrode 17 is also formed on the p-type layer 14. That is, the light-emitting layer 15, and the p-side electrode 17 and the n-side electrode 16 can be formed on the same side of the substrate 11 by removing the active layer 13 and the p-type layer 14 so as to expose the n-type layer 12.

FIG. 6B shows the semiconductor light-emitting element 10 as viewed from the side on which the n-side electrode 16 and the p-side electrode 17 are formed. In the figure, the p-side electrode 17 is shown to occupy a larger area than the n-side electrode 16. However, the present invention is not limited to this configuration, and the area ratio between the p-side electrode 17 and the n-side electrode 16, and the shapes of the p-side electrode 17 and the n-side electrode 16 may be changed as appropriate according to the design of the semiconductor light-emitting element. The n-side electrode 16 may be partially extended along the respective side surfaces of the remaining active layer 13 and the remaining p-side layer 14 with an insulating film therebetween, so as to partially cover the respective surfaces of the p-type layer 14 and the p-side electrode 17. This facilitates connection to the bumps.

The p-side electrode 17 is preferably an electrode made of a material having high reflectance, such as Ag, Al, or Rh, in order to reflect light emitted by the light-emitting layer 15 toward the light-emitting surface 36. It is more desirable to provide between the p-type layer 14 and the p-side electrode 17 a thin film electrode layer such as Pt, Ni, or Co, or a light-transmitting electrode layer such as indium tin oxide (ITO) in order to reduce the ohmic contact resistance between the p-type layer 14 and the p-side electrode 17. Al, Ti, or the like can be used as the n-side electrode 16. It is preferable to form an Au or A1 film on the respective surfaces of the p-side electrode 17 and the n-side electrode 16 in order to increase adhesion strength to the bumps. These electrodes can be formed by a vacuum deposition method, a sputtering method, or the like.

The size of the semiconductor light-emitting element 10 is not specifically limited. However, the above embodiment has a heat dissipation effect especially when a large current is supplied. Thus, it is more preferable that the semiconductor light-emitting element 10 emit a larger amount of light, and have a larger total area. Specifically, it is desirable that the size of the semiconductor light-emitting element 10 be at least 600 $\mu$m by 600 $\mu$m. The semiconductor light-emitting element 10 having a larger total area can operate more like a surface emission light source. Note that although the planar shape of the semiconductor light-emitting element 10 is not limited to a square, it is often convenient to manufacture the semiconductor light-emitting element 10 having a square planar shape.

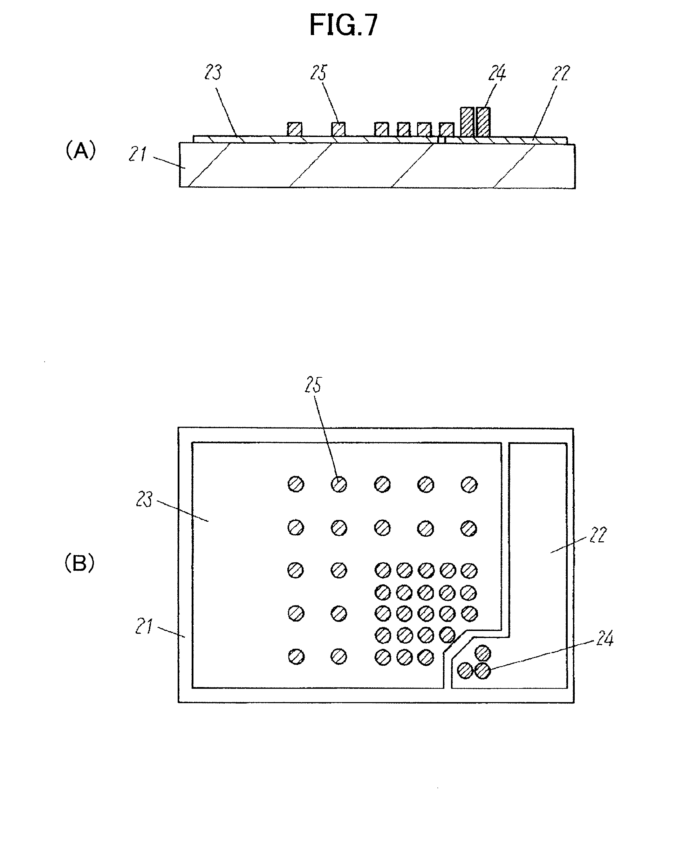

FIG. 7A is a cross-sectional view of the submount 21 and the bumps 24, 25 corresponding to the semiconductor light-emitting device 1 of FIG. 1A. FIG. 7B is a plan view of the submount 21 as viewed from the extended electrode (22, 23) side. A silicon zener diode, a silicon diode, silicon, aluminum nitride, alumina, other ceramic material, or the like can be used as the submount 21.

Although gold, gold-tin, solder, an indium alloy, a conductive polymer, or the like can be used as a material of the bumps 24, 25, gold or a material mainly containing gold is especially preferable. With these materials, the bumps 24, 25 can be formed by a plating method, a vacuum deposition method, a screen printing method, a droplet injection method, a wire bump method, or the like.

For example, in the wire bump method, gold bumps are formed by bonding one ends of gold wires to the extended electrodes 22, 23 on the submount 21 by a bonder, and cutting the wires. In the droplet injection method, a volatile solvent, having dispersed therein fine nanoparticles of a highly conductive material such as gold, is printed by a method similar to an inkjet printing method, and the solvent is volatilized and removed to form bumps as aggregations of the nanoparticles.

A method for individually forming the bumps 24, 25 is especially suitable for forming the bumps of the above semiconductor light-emitting devices, since it is often easy to change the formation positions (the positions where the bumps are to be formed) by changing a program of a forming apparatus.

Note that although the bumps are described above in detail as the connection members, the connection members are not limited to the bumps.

Throughout the specification, Al represents aluminum, N represents nitrogen, C represents carbon, O represents oxygen, Ag represents silver, Rh represents rhodium, Pt represents platinum, Ni represents nickel, Co represents cobalt, Ti represents titanium, Au represents gold, Ga represents gallium, In represents indium, Zn represents zinc, and Si represents silicon.

INDUSTRIAL APPLICABILITY

The present invention can be used for semiconductor light-emitting elements in which an n-side electrode and a p-side electrode are provided over one surface of a substrate, and the other surface of the substrate serves as a light-emitting surface, and semiconductor light-emitting devices using the same.

**Claims**

1. A semiconductor light-emitting device, comprising:

   a submount having a p-side extended electrode and an n-side extended electrode, which are formed on one surface thereof;
   a p-side connection member formed on an upper surface of the p-side extended electrode, and an n-side connection member formed on an upper surface of the n-side extended electrode; and
   a semiconductor light-emitting element having a light-emitting layer on one surface thereof, and having a p-side electrode and an n-side electrode on one surface of the light-emitting layer, the p-side electrode being electrically connected to the p-side extended electrode via the p-side connection member, and the n-side electrode being electrically connected to the n-side extended electrode via the n-side connection member, wherein
   multiple ones of the p-side connection member are provided,
   the one surface of the light-emitting layer is formed by a first region located within a predetermined distance from the n-side electrode, and a second region other than the first region, and the predetermined distance is such that an area of the first region is one third of that of the second region, and
   a sum x of bottom areas of the p-side connection members located in the first region is larger than one third of a sum y of bottom areas of the p-side connection members located in the second region.

2. The semiconductor light-emitting device of claim 1, wherein
   the p-side connection members are a plurality of bumps.

3. The semiconductor light-emitting device of claim 2, wherein the plurality of bumps have the same bottom area.

4. The semiconductor light-emitting device of claim 2, wherein the plurality of bumps include a plurality of types of bumps having different bottom areas from each other.

# FIG.1

(A)

(B)

# FIG.2

(A)

(B)

# FIG.3

(A)

(B)

# FIG.4

(A)

(B)

# FIG.5

(A)

16d

15d

17d

11

204

24d

104

25d

(B)

15e    17e

11

205

105

16e

25e    25z    24e

# FIG.6

(A)

(B)

# FIG.7

(A)

(B)

| INTERNATIONAL SEARCH REPORT | International application No. |
|---|---|
| | PCT/JP2008/003307 |

A. CLASSIFICATION OF SUBJECT MATTER
*H01L33/00*(2006.01)i, *H01L21/60*(2006.01)i, *H01S5/022*(2006.01)i

According to International Patent Classification (IPC) or to both national classification and IPC

B. FIELDS SEARCHED

Minimum documentation searched (classification system followed by classification symbols)
H01L33/00, H01L21/60, H01S5/022

| Documentation searched other than minimum documentation to the extent that such documents are included in the fields searched | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2007-266427 A (Matsushita Electric Industrial Co., Ltd.), 11 October, 2007 (11.10.07), Full text; all drawings (Family: none) | 1-4 |
| A | WO 2006/035664 A1 (Matsushita Electric Industrial Co., Ltd.), 06 April, 2006 (06.04.06), Full text; all drawings & US 2007/0262338 A1 & CN 101027795 A | 1-4 |
| A | JP 2006-093632 A (Matsushita Electric Works, Ltd.), 06 April, 2006 (06.04.06), Full text; all drawings (Family: none) | 1-4 |

| [X] Further documents are listed in the continuation of Box C. | [ ] See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 04 December, 2008 (04.12.08) | 16 December, 2008 (16.12.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2008/003307

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2006-074007 A  (Matsushita Electric Industrial Co., Ltd.), 16 March, 2006 (16.03.06), Full text; all drawings & EP 1794809 A          & WO 2006/013800 A1 | 1-4 |

Form PCT/ISA/210 (continuation of second sheet) (April 2007)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005064412 A
- JP 2003218403 A